# EUROPEAN PATENT APPLICATION

(11) **EP 4 583 498 A1**
(43) Date of publication of application: **09.07.2025**
(21) Application number: 23875108.5
(22) Date of filing: 18.09.2023
(51) Int. Cl.: H04M 1/02, H05K 5/03, H02J 50/10, H05K 1/11, H05K 1/14, G06F 3/0354, G06F 1/16, H02J 7/00

(54) **ELECTRONIC DEVICE INCLUDING SOLENOID TYPE SENSING SUBSTRATE**

(30) Priority: 04.10.2022 KR 20220126426; 06.12.2022 KR 20220168887
(71) Applicant: Samsung Electronics Co., Ltd., Suwon-si, Gyeonggi-do 16677 (KR)
(72) Inventor: OH, Chanhee, Suwon-si, Gyeonggi-do 16677 (KR)
(74) Representative: Nederlandsch Octrooibureau
(86) International application number: PCT/KR2023/014009
(87) International publication number: WO 2024/076040

(57) **Abstract**

According to various embodiments, an electronic device may include a base plate, a side frame connected to the base plate, a front cover covering one side of the base plate, a back cover covering one side of the side frame and provided opposite to the front cover with respect to the side frame, a pen housing disposed on the base plate and capable of accommodating a digital pen, and a solenoid type substrate assembly which is provided between the side frame and the pen housing, and is capable of determining whether the digital pen is provided inside the pen housing and electrically charging the digital pen.

Various other embodiments are possible.

## Description

### TECHNICAL FIELD

Various embodiments of the present disclosure relate to an electronic device, for example, an electronic device including a solenoid type sensing substrate.

### BACKGROUND ART

Recently, digital technology has been developing. Various types of electronic devices such as mobile communication terminals, smartphones, tablets, laptops, wearable devices, and digital cameras are being widely used.

### DISCLOSURE OF THE INVENTION

### TECHNICAL SOLUTIONS

According to embodiments, an electronic device may include a base plate 481, a side frame 482 connected to the base plate, a front cover 491 covering a surface of the base plate, a back cover 494 covering a surface of the side frame, and provided opposite to the front cover with respect to the side frame, a pen housing 470 arranged on the base plate and configured to accommodate a digital pen 501, and a solenoid type substrate assembly 420 provided between the side frame and the pen housing, and configured to determine whether the digital pen is provided inside the pen housing and electrically charge the digital pen.

According to embodiments, an electronic device may include a base plate 481, a side frame 482 connected to the base plate, a front cover 491 covering a surface of the base plate, a back cover 494 covering a surface of the side frame, and provided opposite to the front cover with respect to the side frame, a pen housing 470 arranged on the base plate and configured to accommodate a digital pen 501, and a solenoid type substrate assembly 420 provided between the side frame and the pen housing, and configured to generate one of a first magnetic field that determines whether the digital pen is provided inside the pen housing and a second magnetic field that electrically charges the digital pen.

According to embodiments, an electronic device may include a pen housing 470 configured to accommodate a digital pen 501, and a solenoid type substrate assembly 420 provided between the side frame and the pen housing, and configured to determine whether the digital pen is provided inside the pen housing and electrically charge the digital pen, wherein, the solenoid type substrate assembly 420 may include a plurality of PCBs 421, 422, 423 stacked in a direction parallel to a direction from the side frame toward the pen housing.

### BRIEF DESCRIPTION OF DRAWINGS

FIG. 1 is a block diagram illustrating an electronic device according to an embodiment.
FIG. 2 is a perspective view of a front side of an electronic device according to an embodiment.
FIG. 3 is a perspective view of a rear side of the electronic device of FIG. 2.
FIG. 4 is an exploded perspective view of the electronic device of FIG. 2.
FIG. 5 is a front view schematically showing an internal appearance of an electronic device according to an embodiment.
FIG. 6 is a cross-sectional view along line VI-VI of FIG. 5.
FIG. 7 is a cross-sectional view schematically showing a pen housing and a solenoid type substrate assembly according to an embodiment.
FIG. 8 is a perspective view of a solenoid type substrate assembly according to an embodiment.
FIG. 9 is a front view of a first printed circuit board according to an embodiment.
FIG. 10 is a front view of a second printed circuit board according to an embodiment.
FIG. 11 is a front view of a third printed circuit board according to an embodiment.
FIG. 12 is a cross-sectional view of a solenoid type substrate assembly according to an embodiment.
FIG. 13 is a cross-sectional view of a solenoid type substrate assembly, illustrating a state in which current flows to one of two output ends, according to an embodiment.
FIG. 14 is a cross-sectional view of a solenoid type substrate assembly, illustrating a state in which current flows to the other output end of the two output ends, according to an embodiment.
FIG. 15 is a cross-sectional view of an electronic device according to an embodiment.
FIG. 16 is a cross-sectional view of an electronic device according to an embodiment.
FIG. 17 is a cross-sectional view of an electronic device according to an embodiment.

### BEST MODE FOR CARRYING OUT THE INVENTION

Hereinafter, embodiments will be described in detail with reference to the accompanying drawings. When describing the embodiments with reference to the accompanying drawings, like reference numerals refer to like elements and a repeated description related thereto will be omitted.

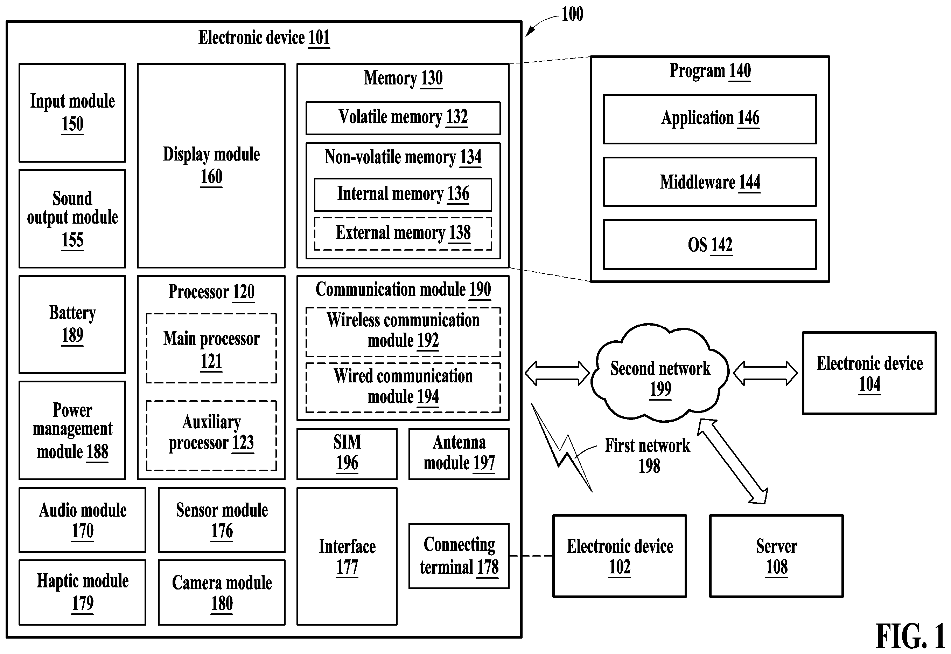

FIG. 1 is a block diagram illustrating an electronic device 101 in a network environment 100 according to various embodiments.

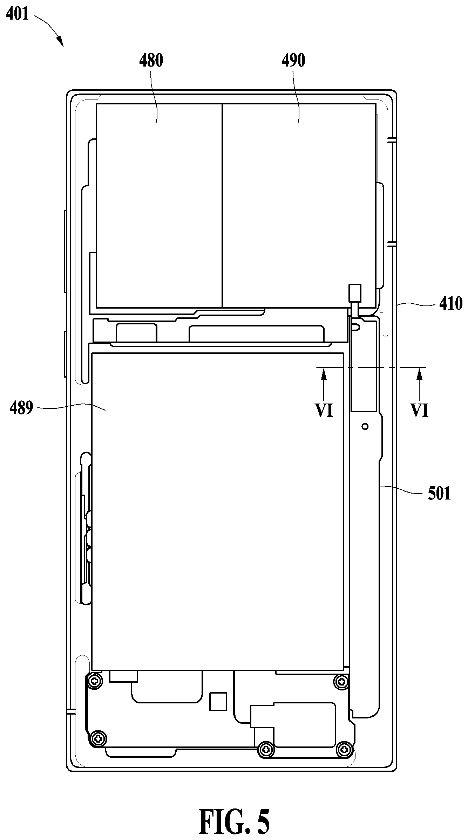

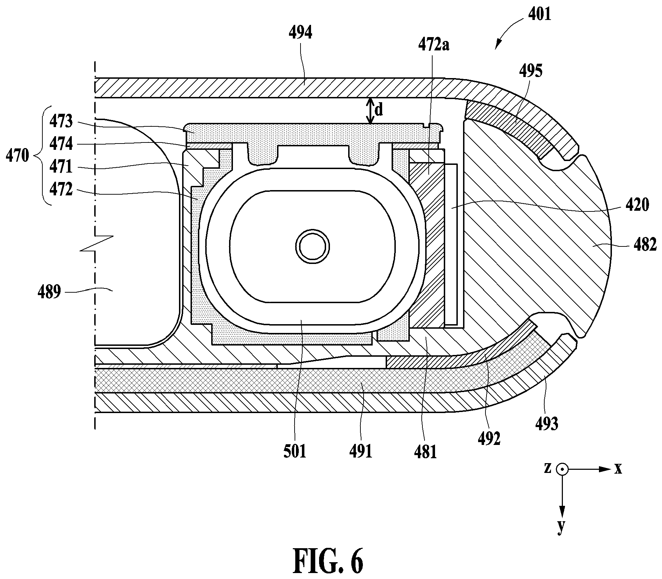

FIG. 6 is a cross-sectional view along line VI-VI of FIG. 5.

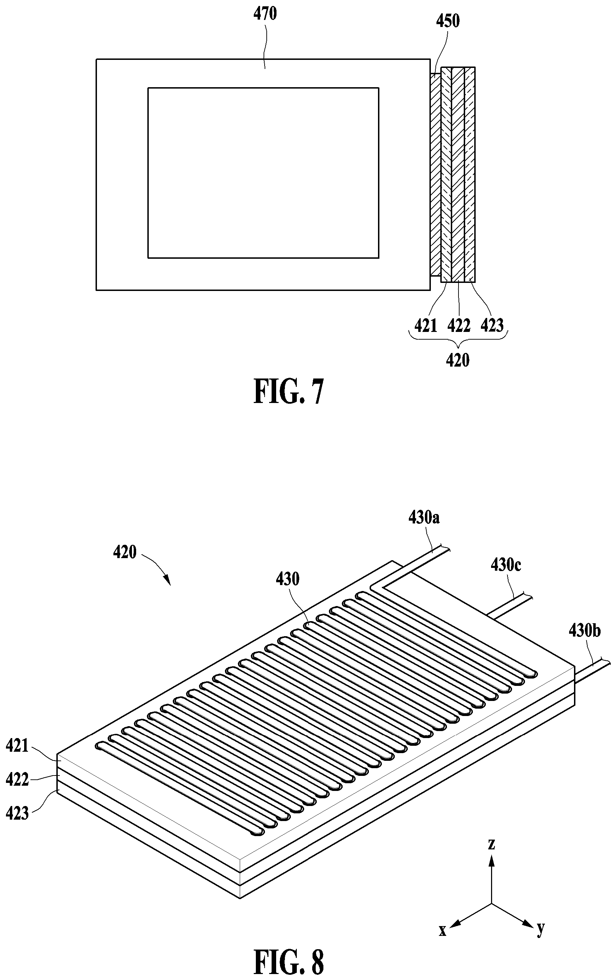

FIG. 7 is a cross-sectional view schematically showing a pen housing and a solenoid type substrate assembly according to an embodiment.

FIG. 8 is a perspective view of a solenoid type substrate assembly according to an embodiment.

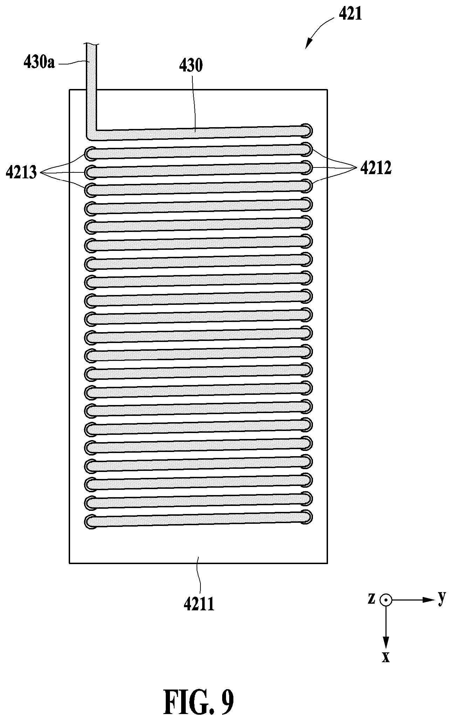

FIG. 9 is a front view of a first printed circuit board according to an embodiment.

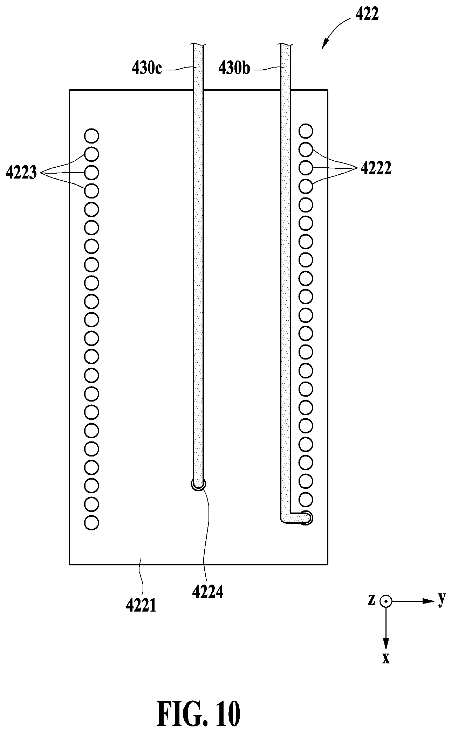

FIG. 10 is a front view of a second printed circuit board according to an embodiment.

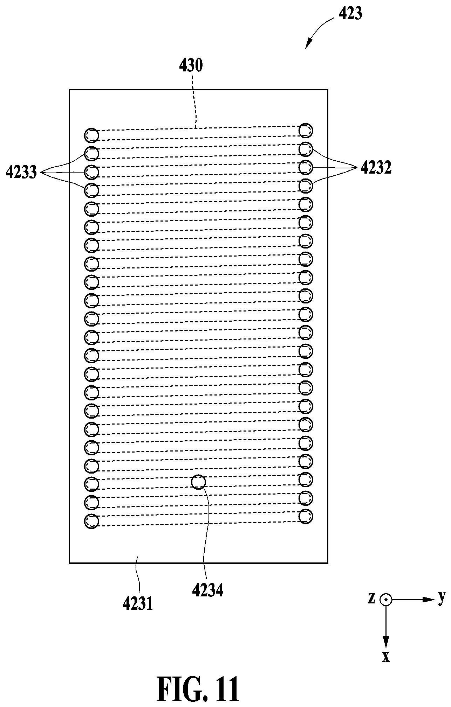

FIG. 11 is a front view of a third printed circuit board according to an embodiment.

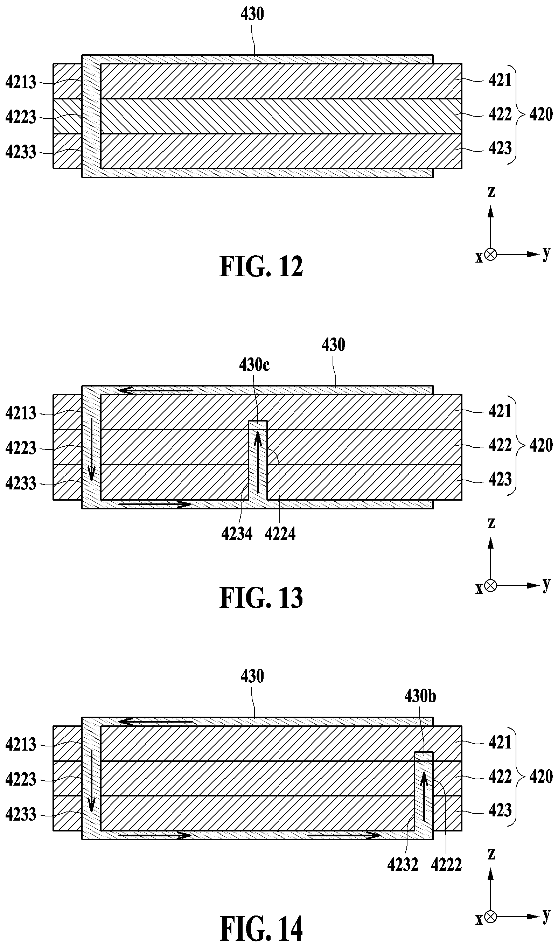

FIG. 12 is a cross-sectional view of a solenoid type substrate assembly according to an embodiment.

FIG. 13 is a cross-sectional view of a solenoid type substrate assembly, illustrating a state in which current flows to one of two output ends, according to an embodiment.

FIG. 14 is a cross-sectional view of a solenoid type substrate assembly, illustrating a state in which current flows to the other output end of the two output ends, according to an embodiment.

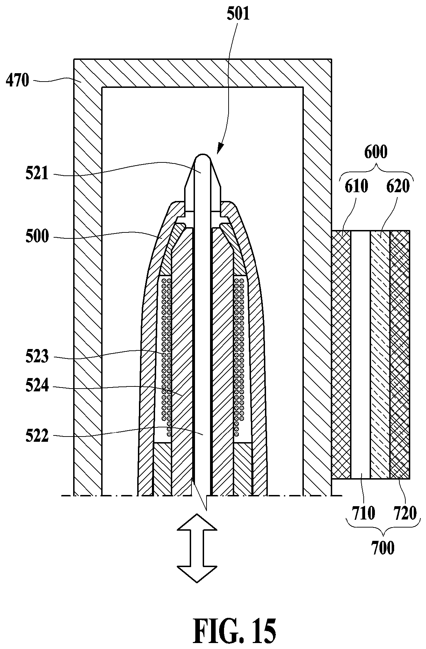

FIG. 15 is a cross-sectional view of an electronic device according to an embodiment.

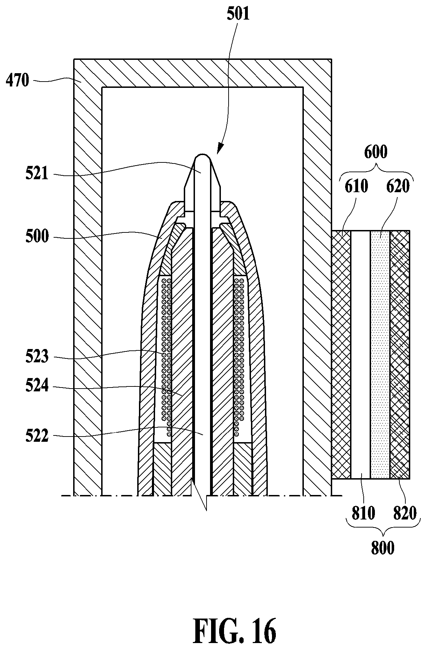

FIG. 16 is a cross-sectional view of an electronic device according to an embodiment.

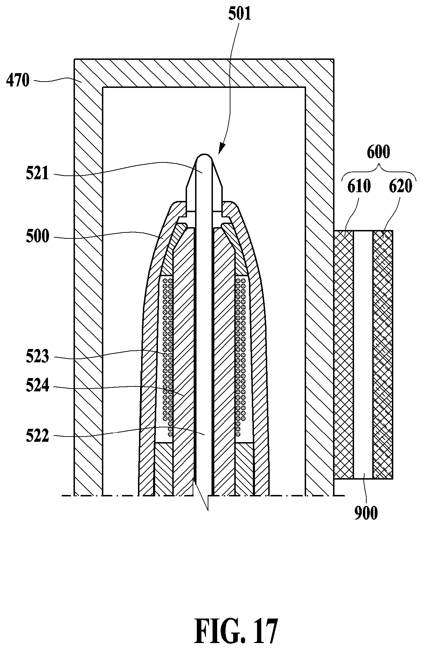

FIG. 17 is a cross-sectional view of an electronic device according to an embodiment.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some of the components (e.g., the sensor module 176, the camera module 180, or the antenna module 197) may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to an embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is in an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. The AI model may be generated by machine learning. Such learning may be performed by, for example, the electronic device 101 in which artificial intelligence is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), and a bidirectional recurrent deep neural network (BRDNN), a deep Q-network, or a combination of two or more thereof, but is not limited thereto. The AI model may additionally or alternatively include a software structure other than the hardware structure.

The memory 130 may store various pieces of data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored as software in the memory 130, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing record. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a display, a hologram device, or a projector and control circuitry to control a corresponding one of the display, the hologram device, or the projector. According to an embodiment, the display module 160 may include a touch sensor adapted to sense a touch, or a pressure sensor adapted to measure an intensity of a force incurred by the touch.

The audio module 170 may convert a sound into an electric signal or vice versa. According to an embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local region network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide region network (WAN)). These various types of communication modules may be implemented as a single component (e.g., a single chip), or may be implemented as multi components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and a next-generation communication technology, e.g., a new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the at least one selected antenna. According to an embodiment, another component (e.g., a radio frequency integrated circuit (RFIC)) other than the radiating element may be additionally formed as a portion of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of the same type as or a different type from the electronic device 101. According to an embodiment, all or some of operations to be executed by the electronic device 101 may be executed at one or more external electronic devices (e.g., the external devices 102 and 104, and the server 108). For example, if the electronic device 101 needs to perform a function or a service automatically, or in response to a request from a user or another device, the electronic device 101, instead of, or in addition to, executing the function or the service, may request one or more external electronic devices to perform at least a portion of the function or the service. The one or more external electronic devices receiving the request may perform the at least part of the function or the service requested, or an additional function or an additional service related to the request, and may transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or MEC. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to the embodiments disclosed herein may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic device is not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B or C", "at least one of A, B and C", and "at least one of A, B, or C", may include any one of, or all possible combinations of the items enumerated together in a corresponding one of the phrases. As used herein, such terms as "1^{st}" and "2^{nd}," or "first" and "second" may be used to simply distinguish a corresponding component from another, and does not limit the components in other aspects (e.g., importance or order). It is to be understood that if a component (e.g., a first component) is referred to, with or without the term "operatively" or "communicatively", as "coupled with", "coupled to", "connected with", or "connected to" another component (e.g., a second component), it means that the component may be coupled with the other component directly (e.g., by wire), wirelessly, or via a third component.

As used in connection with embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to embodiments of the disclosure may be included and provided in a computer program product. The computer program product may be traded as a product between a seller and a buyer. The computer program product may be distributed in the form of a machine-readable storage medium (e.g., compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as a memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components or operations may be omitted, or one or more other components or operations may be added. Alternatively or additionally, a plurality of components (e.g., modules or programs) may be integrated into a single component. In such a case, according to embodiments, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

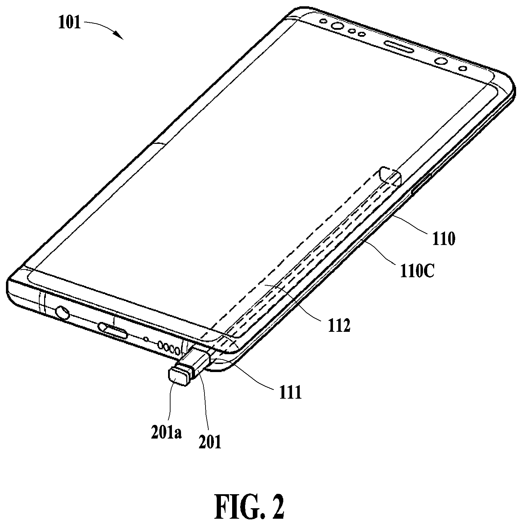

Referring to FIG. 2, according to an embodiment, the electronic device 101 may include the components shown in FIG. 1, and may have a structure into which a digital pen 201 (e.g., a stylus pen) may be inserted. The electronic device 101 may include a housing 110, and may include a hole 111 in a portion, e.g., a portion of a side surface 110C, of the housing 110. The electronic device 101 may include a receiving space 112 connected with the hole 111, and the digital pen 201 may be inserted into the receiving space 112. In the embodiment shown, the digital pen 201 may include a pressable button 201a at an end to be easily pulled out of the receiving space 112 of the electronic device 101. When the button 201a is pressed, a repulsive mechanism (e.g., at least one spring) configured in association with the button 201a may be operated to allow the digital pen 201 to be removed from the receiving space 112.

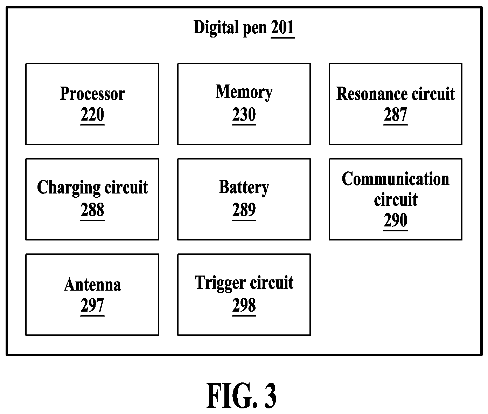

Referring to FIG. 3, according to an embodiment, the digital pen 201 may include a processor 220, a memory 230, a resonance circuit 287, a charging circuit 288, a battery 289, a communication circuit 290, an antenna 297, and/or a trigger circuit 298. According to an embodiment, the processor 220, at least a portion of the resonance circuit 287, and/or at least a portion of the communication circuit 290 of the digital pen 201 may be configured in the form of a chip or on a PCB. The processor 220, the resonance circuit 287, and/or the communication circuit 290 may be electrically connected with the memory 230, the charging circuit 288, the battery 289, the antenna 297, or the trigger circuit 298. According to an embodiment, the digital pen 201 may be composed of only a resonance circuit and a button.

The processor 220 may include a customized hardware module or a generic processor configured to execute software (e.g., an application program). The processor may include a hardware component (function) or software element (program) including at least one of a communication module or a module to manage the state or environment of the digital pen 201, an input/output interface, a data measuring module, and various sensors provided in the digital pen 201. The processor 220 may include one of, for example, hardware, software, or firmware, or a combination of two or more thereof. According to an embodiment, the processor 220 may receive a proximate signal corresponding to an electromagnetic signal generated from a digitizer (e.g., the display module 160) of the electronic device 101 through the resonance circuit 287. When the proximate signal is identified, the processor 220 may control the resonance circuit 287 to transmit an electromagnetic resonance (EMR) input signal to the electronic device 101.

The memory 230 may store information related to an operation of the digital pen 201. For example, the information may include information for communicating with the electronic device 101 and frequency information related to an input operation of the digital pen 201.

The resonance circuit 287 may include at least one of a coil, an inductor, or a capacitor. The resonance circuit 287 of the digital pen 201 may generate a signal having a resonance frequency. For example, to generate the signal, the digital pen 201 may use at least one of an EMR scheme, an active electrostatic (AES) scheme, or an electrically coupled resonance (ECR) scheme. When the digital pen 201 transmits signals via the EMR scheme, the digital pen 201 may generate a signal having a resonance frequency based on an electromagnetic field generated from the inductive panel of the electronic device 101. When the digital pen 201 transmits signals via the AES scheme, the digital pen 201 may generate a signal using a capacitive coupling with the electronic device 101. When the digital pen 201 transmits signals via the ECR scheme, the digital pen 201 may generate a signal having a resonance frequency based on an electric field generated from a capacitive device of the electronic device. According to an embodiment, the resonance circuit 287 may be used to vary the frequency or strength of an electromagnetic field according to a user's manipulation state. For example, the resonance circuit 287 may provide a frequency to recognize a hovering input, drawing input, button input, or erasing input.

When connected with the resonance circuit 287 based on a switching circuit, the charging circuit 288 may rectify a resonance signal generated from the resonance circuit 287 into a direct current (DC) signal and provide the DC signal to the battery 289. According to an embodiment, the digital pen 201 may identify whether the digital pen 201 is inserted in the electronic device 101 using a voltage level of a DC signal sensed by the charging circuit 288.

The battery 289 may be configured to store the power required to operate the digital pen 201. The battery may include, for example, a lithium-ion battery or a capacitor and may be recharged or replaced. According to an embodiment, the battery 289 may be charged with power (e.g., DC signal (DC power)) received from the charging circuit 288.

The communication circuit 290 may be configured to perform wireless communication between the digital pen 201 and the communication module 190 of the electronic device 101. According to an embodiment, the communication circuit 290 may transmit input information and state information about the digital pen 201 to the electronic device 101 using a short-range communication scheme. For example, the communication circuit 290 may transmit direction information (e.g., motion sensor data) about the digital pen 201 obtained through the trigger circuit 298, voice information entered through a microphone, or remaining power information about the battery 289 to the electronic device 101. As an example, the short-range communication scheme may include at least one of Bluetooth, Bluetooth low energy (BLE), or wireless local area network (WLAN).

The antenna 297 may be used to transmit signals or power to the outside (e.g., the electronic device 101) or receive signals or power from the outside. According to an embodiment, the digital pen 201 may include a plurality of antennas 297 and select at least one antenna 297 appropriate for a communication scheme from among the plurality of antennas. The communication circuit 290 may exchange signals or power with an external electronic device through the at least one selected antenna 297.

The trigger circuit 298 may include at least one button or sensor circuit. According to an embodiment, the processor 220 may identify an input scheme (e.g., touch or press) or type (e.g., EMR button or BLE button) of the button of the digital pen 201. According to an embodiment, the sensor circuit may generate an electrical signal or data value corresponding to an internal operating state or external environmental state of the digital pen 201. For example, the sensor circuit may include at least one of a motion sensor, a remaining battery sensor, a pressure sensor, a light sensor, a temperature sensor, a geomagnetic sensor, or a biometric sensor. According to an embodiment, the trigger circuit 298 may transmit a trigger signal to the electronic device 101 using a signal through a sensor or a button input signal.

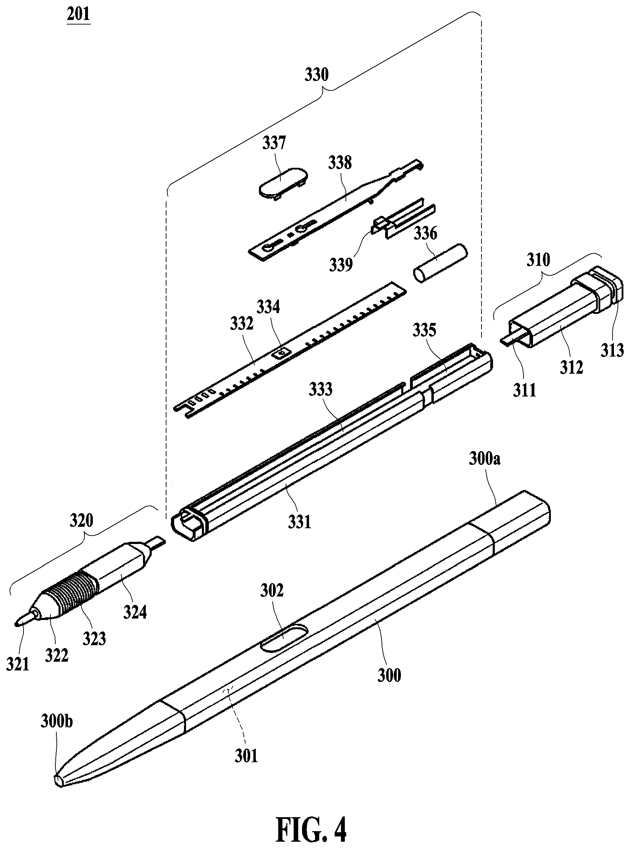

Referring to FIG. 4, the digital pen 201 may include a pen housing 300 that makes up the exterior of the digital pen 201 and an inner assembly inside the pen housing 300. In the embodiment shown, the inner assembly, including all of the components to be mounted inside the pen, may be inserted into the pen housing 300 in a single assembly operation.

The pen housing 300 may have a long shape extended between a first end portion 300a and a second end portion 300b, and may include the receiving space 112 therein. The pen housing 300 may have an elliptical cross-section with a long axis and a short axis, and may be formed overall in the shape of an elliptical pillar. A receiving space 301 of the electronic device 101 may also be formed with an elliptical cross-section corresponding to the shape of the pen housing 300. The pen housing 300 may include a synthetic resin (e.g., plastic) and/or a metallic material (e.g., aluminum). According to an embodiment, the second end portion 300b of the pen housing 300 may be made of synthetic resin material.

The inner assembly may have a long, extended shape corresponding to the shape of the pen housing 300. The inner assembly may be broadly divided into three components along the longitudinal direction. For example, the inner assembly may include an ejection member 310 arranged at a position corresponding to the first end portion 300a of the pen housing 300, a coil portion 320 arranged at a position corresponding to the second end portion 300b of the pen housing 300, and a circuit board portion 330 arranged at a position corresponding to the body of the housing.

The ejection member 310 may include a component for removing the digital pen 201 from the receiving space 112 of the electronic device 101. According to an embodiment, the ejection member 310 may be arranged around a shaft 311 and may include an ejection body 312 and a button portion 313 that form the overall outer shape of the ejection member 310. When the inner assembly is fully inserted into the pen housing 300, the portion including the shaft 311 and the ejection body 312 may be surrounded by the first end portion 300a of the pen housing 300, and the button portion 313 (e.g., 201a in FIG. 2) may be exposed to the outside of the first end portion 300a. A plurality of parts not shown, for example, cam members or elastic members, may be disposed within the ejection body 312 to form a push-pull structure. In an embodiment, the button portion 313 may be substantially coupled with the shaft 311 to perform a linear reciprocating motion with respect to the ejection body 312. According to embodiments, the button portion 313 may include a button having a catch structure formed such that a user may pull out the digital pen 201 using a fingernail. According to an embodiment, the digital pen 201 may provide another input scheme by including a sensor that detects a linear reciprocating motion of the shaft 311.

The coil portion 320 may include a pen tip 321, which is exposed to the outside of the second end portion 300b when the internal assembly is fully inserted into the pen housing 300, a packing ring 322, a multi-turn coil 323 and/or a pressure sensing portion 324 for obtaining a change in pressure according to the pressurization of the pen tip 321. The packing ring 322 may include epoxy, rubber, urethane, or silicone. The packing ring 322 may be provided for waterproofing and dustproofing purposes, and may protect the coil portion 320 and the circuit board portion 330 from submersion or dust. According to an embodiment, the coil 323 may form a resonant frequency in a set frequency band (e.g., 500 kHz), and may be combined with at least one element (e.g., a capacitive element) to adjust the resonant frequency formed by the coil 323 within a predetermined range.

The circuit board portion 330 may include a PCB 332, a base 331 surrounding at least a surface of the PCB 332, and an antenna. According to an embodiment, a substrate seating portion 333 on which the PCB 332 is arranged may be formed on an upper surface of the base 331, and the PCB 332 may be fixed while seated on the substrate seating portion 333. According to an embodiment, the PCB 332 may include an upper surface and a lower surface, and a variable capacitor or switch 334 connected to the coil 323 may be arranged on the upper surface, and a charging circuit, a battery, or a communication circuit may be arranged on the lower surface. The battery may include an electric double layer capacitor (EDLC). The charging circuit may be arranged between the coil 323 and the battery, and may include a voltage detector circuitry and a rectifier.

The antenna may include an antenna structure 339 such as the example illustrated in FIG. 4 and/or an antenna embedded in the PCB 332. According to embodiments, the switch 334 may be provided on the PCB 332. A side button 337 provided in the digital pen 201 may be used to press the switch 334, and may be exposed to the outside via a side opening 302 of the pen housing 300. The side button 337 may be supported by a supporting member 338, and when there is no external force acting on the side button 337, the supporting member 338 may provide elastic restoring force to restore or maintain the side button 337 in a predetermined position.

The circuit board portion 330 may include another packing ring such as an O-ring. For example, an O-ring made of elastic material may be arranged on both ends of the base 331 such that a sealing structure may be formed between the base 331 and the pen housing 300. In an embodiment, the supporting member 338 may partially form a sealing structure by closely contacting an inner wall of the pen housing 300 around the side opening 302. For example, the circuit board portion 330 may also form a waterproofing/dustproofing structure similar to that of the packing ring 322 of the coil portion 320.

The digital pen 201 may include a battery seating portion 335 in which a battery 336 is arranged on the upper surface of the base 331. The battery 336 that may be mounted on the battery seating portion 335 may include, for example, a cylinder type battery.

The digital pen 201 may include a microphone (not shown). The microphone may be directly connected to the PCB 332, or connected to a separate flexible printed circuit board (FPCB) (not shown) connected to the PCB 332. According to embodiments, the microphone may be arranged in a position parallel to the side button 337 in a longitudinal direction of the digital pen 201.

FIG. 5 is a front view schematically showing an internal appearance of an electronic device according to an embodiment. FIG. 6 is a cross-sectional view along line VI-VI of FIG. 5.

Referring to FIGS. 5 and 6, an electronic device 401 (e.g., the electronic device 101 of FIG. 1) may accommodate various components therein. For example, the electronic device 401 may include a processor 490, a camera module 480, and a battery 489. The electronic device 401 may accommodate a digital pen 501 (e.g., the digital pen 201 of FIG. 2). The electronic device 401 may provide a space to accommodate the digital pen 501. For example, a receiving space of the electronic device 401 may be provided at a side portion of the battery 489. The position of the receiving space is only an example and is not limited thereto.

The electronic device 401 may include a base plate 481, a side frame 482, a front cover 491, a front connecting member 492, a display 493, a back cover 494, a back connecting member 495, a pen housing 470, and a solenoid type substrate assembly 420. As used herein, the base plate 481, the side frame 482, the front cover 491, and the back cover 494 may also be referred to as a housing (e.g., the housing 110 of FIG. 2). The thickness of the electronic device 401 may correspond to a distance between an outer surface of the front cover 491 and an outer surface of the back cover 494. As the distance between the front cover 491 and the back cover 494 becomes relatively narrower, the overall thickness of the electronic device 401 may be thinner.

The electronic device 401 may be implemented with a thinner thickness by arranging the solenoid type substrate assembly 420 on the side portion of the pen housing 470. The solenoid type substrate assembly 420 may be arranged on the side portion of the pen housing 470 and may have a thinner thickness than the pen housing 470.

The base plate 481 may have a flat plate shape. A surface of the base plate 481 may face the front cover 491, and the other surface of the base plate 481 may face the back cover 494. The base plate 481 may support the pen housing 470.

The side frame 482 may be connected to the base plate 481. The side frame 482 may be formed to extend in a -y direction from the base plate 481 to secure a receiving space on the base plate 481. The height in a y-axis direction of the side frame 482 may correspond to the height of the receiving space. An outer surface of the side frame 482 may be exposed to the outside. A +z-axis direction end of the side frame 482 may be exposed to the outside. The +z-axis direction end of the side frame 482 may be rounded.

The front cover 491 may cover a surface of the base plate 481. The front cover 491 may cover a surface of the base plate 481 facing a +y direction. The front cover 491 may include a plurality of PCBs (not shown). The front cover 491 may support the display 493. The front connecting member 492 may connect the front cover 491 and the base plate 481. For example, the front connecting member 492 may be an adhesive layer.

The display 493 may be arranged on the front cover 491. The display 493 may receive an electrical signal through the processor 490 and the front cover 491. The display 493 may externally display an image that is identifiable to a user's naked eye.

The back cover 494 may be connected to the side frame 482. The back cover 494 may protect the components arranged on the base plate 481. The back connecting member 495 may connect the back cover 494 and the side frame 482. For example, the back connecting member 495 may be an adhesive layer.

The pen housing 470 may accommodate the digital pen 501 (e.g., the digital pen 201 of FIG. 2). The pen housing 470 may guide the digital pen 501 to move in an x-axis direction. The pen housing 470 may include a housing frame 471, a housing guide 472, a pen cover 473, and a pen connecting member 474.

The housing frame 471 may be arranged on the base plate 481.

The housing guide 472 may be provided inside the base plate 481, and may guide the movement of the digital pen 501.

The pen cover 473 may be arranged on the housing frame 471 and the housing guide 472. The pen cover 473 may cover a surface of the digital pen 501. The pen connecting member 474 may connect the pen cover 473 to the housing frame 471 and the housing guide 472.

The solenoid type substrate assembly 420 may determine whether the digital pen 501 is inserted into the pen housing 470, and may charge the digital pen 501. The solenoid type substrate assembly 420 may generate two different magnetic fields to perform their respective functions. The solenoid type substrate assembly 420 may generate a first signal and a second signal having different frequencies. The solenoid type substrate assembly 420 may have two output ends. Depending on which of the two output ends the current flowing in the solenoid type substrate assembly 420 exits through, the magnetic field generated in the solenoid type substrate assembly 420 may be determined. The solenoid type substrate assembly 420 may determine whether the digital pen 501 is inserted by generating one of the first signal and the second signal. The solenoid type substrate assembly 420 may charge the digital pen 501 by generating the other one of the first signal and the second signal.

The solenoid type substrate assembly 420 may be provided between the side frame 482 and the pen housing 470. The solenoid type substrate assembly 420 may be provided at a position spaced apart from the pen cover 473. The solenoid type substrate assembly 420 may be arranged in a manner intersecting the pen cover 473. The solenoid type substrate assembly 420 and the pen cover 473 may not be provided in parallel. The solenoid type substrate assembly 420 and the pen cover 473 may not overlap each other in the y-axis direction. Since the solenoid type substrate assembly 420 is spaced apart from the pen cover 473, a thickness d of an upper space of the pen housing 470 may be relatively greater compared to a state in which the solenoid type substrate assembly 420 is arranged parallel to the pen cover 473. When there is room in the upper space of the pen housing 470, other components may be arranged therein, or the electronic device 401 may be made slimmer.

FIG. 7 is a cross-sectional view schematically showing a pen housing and a solenoid type substrate assembly according to an embodiment. FIG. 8 is a perspective view of a solenoid type substrate assembly according to an embodiment.

Referring to FIGS. 7 and 8, the solenoid type substrate assembly 420 may be connected to a side surface of the pen housing 470. The solenoid type substrate assembly 420 may be connected to the pen housing 470 by a connecting layer 450. For example, the connecting layer 450 may be an adhesive layer.

The solenoid type substrate assembly 420 may include a plurality of PCBs 421, 422, and 423 stacked in a direction parallel to the direction from a side frame (e.g., the side frame 482 of FIG. 6) toward the pen housing 470. For example, the plurality of PCBs 421, 422, and 423 may be FPCBs. The solenoid type substrate assembly 420 may include the coil 430 wound on the plurality of PCBs 421, 422, and 423. The solenoid type substrate assembly 420 may generate a magnetic field. The solenoid type substrate assembly 420 may generate two different types of magnetic fields. The solenoid type substrate assembly 420 may adjust the frequency by selecting an output end of the current flowing through the coil 430. The magnetic field generated in the solenoid type substrate assembly 420 may be determined by the frequency.

The solenoid type substrate assembly 420 may include the plurality of PCBs 421, 422, and 423 stacked in a z-axis direction. The normal direction of the plurality of PCBs 421, 422, and 423 may be parallel to the z-axis direction. The solenoid type substrate assembly 420 may include the coil 430 wound on the plurality of PCBs 421, 422, and 423. The coil 430 may include one input end 430a and two output ends 430b and 430c. The current flowing along the coil 430 may flow outward through either of the two output ends. For example, a processor (e.g., the processor 120 of FIG. 1) may determine the output end of the coil 430. By the output end, a path of the current flowing along the coil 430 may be determined. The path of the current flowing along the coil 430 may be provided equal to the number of output ends. For example, when there are two output ends, there may be two paths for the current. Depending on the length of the current path, the frequency may be determined differently.

FIG. 9 is a front view of a first PCB according to an embodiment. FIG. 10 is a front view of a second PCB according to an embodiment. FIG. 11 is a front view of a third PCB according to an embodiment.

FIG. 12 is a cross-sectional view of a solenoid type substrate assembly according to an embodiment. FIG. 13 is a cross-sectional view of a solenoid type substrate assembly, illustrating a state in which current flows to one of two output ends, according to an embodiment. FIG. 14 is a cross-sectional view of a solenoid type substrate assembly, illustrating a state in which current flows to the other output end of the two output ends, according to an embodiment.

Referring to FIGS. 9 to 14, the first PCB 421 may include a first PCB body 4211, a first right side via 4212, and a first left side via 4213. The first right side via 4212 and the first left side via 4213 may be formed to penetrate the first PCB body 4211. The first right side via 4212 may be arranged in a row spaced apart from each other in an x-axis direction on the right side of the first PCB body 4211. The first left side via 4213 may be arranged in a row in the x-axis direction on the left side of the first PCB body 4211. The first right side via 4212 and the first left side via 4213 may be provided spaced apart in a y-axis direction.

The second PCB 422 may include a second PCB body 4221, a second right side via 4222, and a second left side via 4223. The second right side via 4222 and the second left side via 4223 may be formed to penetrate the second PCB body 4221. The second right side via 4222 may be arranged in a row spaced apart from each other in the x-axis direction on the right side of the second PCB body 4221. The second left side via 4223 may be arranged in a row in the x-axis direction on the left side of the second PCB body 4221. The second right side via 4222 and the second left side via 4223 may be provided spaced apart in the y-axis direction. The second PCB 422 may include an output via 4224. The output via 4224 may guide a portion of the coil 430 to one (e.g., the output end 430c) of the output ends. The second right side via 4222 or the second left side via 4223 may guide a portion of the coil 430 to the other one (e.g., the output end 430b) of the output ends.

The third PCB 423 may include a third PCB body 4231, a third right side via 4232, and a third left side via 4233. The third right side via 4232 and the third left side via 4233 may be formed to penetrate the third PCB body 4231. The third right side via 4232 may be arranged in a row spaced apart from each other in the x-axis direction on the right side of the third PCB body 4231. The third left side via 4233 may be arranged in a row in the x-axis direction on the left side of the third PCB body 4231. The third right side via 4232 and the third left side via 4233 may be provided spaced apart in the y-axis direction. The third PCB 423 may include an output via 4234. The output via 4234 may guide a portion of the coil 430 to one (e.g., the output end 430c) of the output ends. The third right side via 4232 or the third left side via 4233 may guide a portion of the coil 430 to the other one (e.g., the output end 430b) of the output ends.

Depending on the output end through which the current flows, the path through which the current flows may be determined, and the magnetic field generated by the solenoid type substrate assembly may be determined.

FIG. 15 is a cross-sectional view of an electronic device according to an embodiment.

Referring to FIG. 15, the digital pen 501 may move along the pen housing 470. The digital pen 501 may include a pen housing 500, a pen tip 521, a pen core 522, a pen coil 523, and a pen magnet 524. The pen housing 500 may form the external shape of the pen. The pen core 522 may be provided inside the pen housing 500. The pen core 522 may be provided along the center of the pen housing 500. The pen tip 521 may be provided at an end of the pen core 522. The pen magnet 524 may surround the pen core 522. The pen coil 523 may be wound around the pen magnet 524.

A solenoid type substrate assembly 600 may include a plurality of PCBs. For example, the solenoid type substrate assembly 600 may include three PCBs. The solenoid type substrate assembly 600 may include a first PCB module 610 and a second PCB module 620. The first PCB module 610 and the second PCB module 620 may each include at least one PCB. For example, the first PCB module 610 may include a first PCB (e.g., the first PCB 421 of FIG. 8), and the second PCB module 620 may include a second PCB (e.g., the second PCB 422 of FIG. 8) and a third PCB (e.g., the third PCB 423 of FIG. 8). For example, the first PCB module 610 may include the first PCB (e.g., the first PCB 421 of FIG. 8) and the second PCB (e.g., the second PCB 422 of FIG. 8), and the second PCB module 620 may include the third PCB (e.g., the third PCB 423 of FIG. 8).

The solenoid type substrate assembly 600 may include an induction module 700 to induce a generated magnetic field toward the digital pen 501. For example, the induction module 700 may include a magnetic layer 710 and a shield layer 720.

The magnetic layer 710 may strengthen a magnetic field generated in the solenoid type substrate assembly 600. For example, the magnetic layer 710 may strengthen the magnetic flux of the magnetic field passing through the digital pen 501. The pen magnet 524 may attract the magnetic field generated in the solenoid type substrate assembly 600, thereby inducing more magnetic flux to gather around the pen coil 523. When the magnetic flux passes through the pen coil 523, an induced electromotive force may be generated in the pen coil 523. When the induced electromotive force is generated in the pen coil 523, a charging operation of the digital pen 501 may be implemented.

The shield layer 720 may induce magnetic flux to not leak in a direction other than the pen coil 523. The shield layer 720 may block a magnetic field leaking in the opposite direction so that the magnetic field generated in the solenoid type substrate assembly 600 may be induced toward the pen coil 523.

FIG. 16 is a cross-sectional view of an electronic device according to an embodiment.

Referring to FIG. 16, the digital pen 501 may move along the pen housing 470. The digital pen 501 may include the pen housing 500, the pen tip 521, the pen core 522, the pen coil 523, and the pen magnet 524.

The solenoid type substrate assembly 600 may include a plurality of PCBs. For example, the solenoid type substrate assembly 600 may include three PCBs. The solenoid type substrate assembly 600 may include the first PCB module 610 and the second PCB module 620. The first PCB module 610 and the second PCB module 620 may each include at least one PCB. For example, the first PCB module 610 may include a first PCB (e.g., the first PCB 421 of FIG. 8), and the second PCB module 620 may include a second PCB (e.g., the second PCB 422 of FIG. 8) and a third PCB (e.g., the third PCB 423 of FIG. 8). For example, the first PCB module 610 may include the first PCB (e.g., the first PCB 421 of FIG. 8) and the second PCB (e.g., the second PCB 422 of FIG. 8), and the second PCB module 620 may include the third PCB (e.g., the third PCB 423 of FIG. 8).

The solenoid type substrate assembly 600 may include an induction module 800 to induce a generated magnetic field toward the digital pen 501. For example, the induction module 800 may include an adhesive layer 810 and a shield layer 820.

The adhesive layer 810 may connect the first PCB module 610 and the second PCB module 620. The adhesive layer 810 may not be magnetic.

FIG. 17 is a cross-sectional view of an electronic device according to an embodiment.

Referring to FIG. 17, the digital pen 501 may move along the pen housing 470. The digital pen 501 may include the pen housing 500, the pen tip 521, the pen core 522, the pen coil 523, and the pen magnet 524.

The solenoid type substrate assembly 600 may include a plurality of PCBs. For example, the solenoid type substrate assembly 600 may include three PCBs. The solenoid type substrate assembly 600 may include the first PCB module 610 and the second PCB module 620. The first PCB module 610 and the second PCB module 620 may each include at least one PCB. For example, the first PCB module 610 may include a first PCB (e.g., the first PCB 421 of FIG. 8), and the second PCB module 620 may include a second PCB (e.g., the second PCB 422 of FIG. 8) and a third PCB (e.g., the third PCB 423 of FIG. 8). For example, the first PCB module 610 may include the first PCB (e.g., the first PCB 421 of FIG. 8) and the second PCB (e.g., the second PCB 422 of FIG. 8), and the second PCB module 620 may include the third PCB (e.g., the third PCB 423 of FIG. 8).

The solenoid type substrate assembly 600 may include an induction module 900 to induce a generated magnetic field toward the digital pen 501. The induction module 900 may include a magnet. The induction module 900 may strengthen a magnetic field generated in the solenoid type substrate assembly 600. For example, induction module 900 may strengthen the magnetic flux of the magnetic field passing through the digital pen 501. The pen magnet 524 may attract the magnetic field generated in the solenoid type substrate assembly 600, thereby inducing more magnetic flux to gather around the pen coil 523. When the magnetic flux passes through the pen coil 523, an induced electromotive force may be generated in the pen coil 523. When the induced electromotive force is generated in the pen coil 523, a charging operation of the digital pen 501 may be implemented.

According to embodiments, an electronic device may include a base plate 481, a side frame 482 connected to the base plate, a front cover 491 covering a surface of the base plate, a back cover 494 covering a surface of the side frame, and provided opposite to the front cover with respect to the side frame, a pen housing 470 arranged on the base plate and configured to accommodate a digital pen 501, and a solenoid type substrate assembly 420 provided between the side frame and the pen housing, and configured to determine whether the digital pen is provided inside the pen housing and electrically charge the digital pen.

According to embodiments, the solenoid type substrate assembly 420 may include a plurality of PCBs 421, 422, 423 stacked in a direction parallel to a direction from the side frame toward the pen housing.

According to embodiments, the pen housing 470 may include a housing frame 471 arranged on the base plate, and a pen cover 472 arranged on the housing frame and provided parallel to the back cover.

According to embodiments, the solenoid type substrate assembly 420 may be provided at a position spaced apart from the pen cover 470.

According to embodiments, the pen cover 470 may be arranged to face a rear surface of the digital pen 501, and the solenoid type substrate assembly 420 may be arranged to face a side surface of the digital pen 501.

According to embodiments, the solenoid type substrate assembly 420 may be configured to generate two different magnetic fields.

According to embodiments, the solenoid type substrate assembly 420 may be configured to generate one of a first magnetic field for identifying a position of the digital pen and a second magnetic field for charging the digital pen.

According to embodiments, the solenoid type substrate assembly 420 may include a first PCB 421, a second PCB 422, and a third PCB 423 sequentially stacked in a direction parallel to the direction from the side frame toward the pen housing, and a coil 430 wound on the first PCB, the second PCB, and the third PCB.

According to embodiments, the first PCB 421, the second PCB 422, and the third PCB 423 may each include a PCB body and a plurality of side vias formed penetrating the PCB body.

According to embodiments, the coil 430 may include one input end arranged on the first PCB and two output ends arranged on the second PCB.

According to embodiments, a current flowing along the coil may enter the coil through the input end and exit the coil through one of the two output ends.

According to embodiments, one of the first PCB and the third PCB may further include an output via formed penetrating the PCB body and provided at a position spaced apart from the side via.

According to embodiments, the solenoid type substrate assembly 420 may further include a magnetic layer 710 having magnetism and arranged between two adjacent PCBs among the first PCB, the second PCB, and the third PCB.

According to embodiments, the solenoid type substrate assembly 420 may further include a shield layer 720 provided opposite to the pen housing with respect to the first PCB, the second PCB, and the third PCB.

According to embodiments, the base plate 481 and the side frame 482 may be formed integrally.

According to embodiments, an electronic device may include a base plate 481, a side frame 482 connected to the base plate, a front cover 491 covering a surface of the base plate, a back cover 494 covering a surface of the side frame, and provided opposite to the front cover with respect to the side frame, a pen housing 470 arranged on the base plate and configured to accommodate a digital pen 501, and a solenoid type substrate assembly 420 provided between the side frame and the pen housing, and configured to generate one of a first magnetic field that determines whether the digital pen is provided inside the pen housing and a second magnetic field that electrically charges the digital pen.

According to embodiments, the solenoid type substrate assembly 420 may include a plurality of PCBs 421, 422, 423 stacked in a direction parallel to a direction from the side frame toward the pen housing.

According to embodiments, the solenoid type substrate assembly 420 may include a first PCB 421, a second PCB 422, and a third PCB 423 sequentially stacked in a direction parallel to the direction from the side frame toward the pen housing, and a coil 430 wound on the first PCB, the second PCB, and the third PCB.

According to embodiments, the coil 430 may include one input end arranged on the first PCB and two output ends arranged on the second PCB.

According to embodiments, an electronic device may include a pen housing 470 configured to accommodate a digital pen 501, and a solenoid type substrate assembly 420 provided between the side frame and the pen housing, and configured to determine whether the digital pen is provided inside the pen housing and electrically charge the digital pen, wherein, the solenoid type substrate assembly 420 may include a plurality of PCBs 421, 422, 423 stacked in a direction parallel to a direction from the side frame toward the pen housing.

## Claims

1. An electronic device comprising a solenoid type substrate assembly, comprising:
a base plate 481;
a side frame 482 connected to the base plate;
a front cover 491 covering a surface of the base plate;
a back cover 494 covering a surface of the side frame, and provided opposite to the front cover with respect to the side frame;
a pen housing 470 arranged on the base plate and configured to accommodate a digital pen 501; and
a solenoid type substrate assembly 420 provided between the side frame and the pen housing, and configured to determine whether the digital pen is provided inside the pen housing and electrically charge the digital pen.

2. The electronic device of claim 1, wherein
the solenoid type substrate assembly 420 comprises a plurality of printed circuit boards (PCBs) 421, 422, 423 stacked in a direction parallel to a direction from the side frame toward the pen housing.

3. The electronic device of claims 1 or 2, wherein
the pen housing 470 comprises:
a housing frame 471 arranged on the base plate; and
a pen cover 472 arranged on the housing frame and provided parallel to the back cover.

4. The electronic device of any one of claims 1 to 3, wherein
the solenoid type substrate assembly 420 is provided at a position spaced apart from the pen cover 470.

5. The electronic device of any one of claims 1 to 4, wherein
the pen cover 470 is arranged to face a rear surface of the digital pen 501, and the solenoid type substrate assembly 420 is arranged to face a side surface of the digital pen 501.

6. The electronic device of any one of claims 1 to 5, wherein
the solenoid type substrate assembly 420 is configured to generate two different magnetic fields.

7. The electronic device of any one of claims 1 to 6, wherein
the solenoid type substrate assembly 420 is configured to generate one of a first magnetic field for identifying a position of the digital pen and a second magnetic field for charging the digital pen.

8. The electronic device of any one of claims 1 to 7, wherein
the solenoid type substrate assembly 420 comprises:
a first PCB 421, a second PCB 422, and a third PCB 423 sequentially stacked in a direction parallel to the direction from the side frame toward the pen housing; and
a coil 430 wound on the first PCB, the second PCB, and the third PCB.

9. The electronic device of any one of claims 1 to 8, wherein
the first PCB 421, the second PCB 422, and the third PCB 423 each comprise a PCB body and a plurality of side vias formed penetrating the PCB body.

10. The electronic device of any one of claims 1 to 9, wherein
the coil 430 comprises one input end arranged on the first PCB and two output ends arranged on the second PCB.

11. The electronic device of any one of claims 1 to 10, wherein
a current flowing along the coil enters the coil through the input end and exits the coil through one of the two output ends.

12. The electronic device of any one of claims 1 to 11, wherein
one of the first PCB and the third PCB further comprises
an output via formed penetrating the PCB body and provided at a position spaced apart from the side via.

13. The electronic device of any one of claims 1 to 12, wherein
the solenoid type substrate assembly 420 further comprises
a magnetic layer 710 having magnetism and arranged between two adjacent PCBs among the first PCB, the second PCB, and the third PCB.

14. The electronic device of any one of claims 1 to 13, wherein
the solenoid type substrate assembly 420 further comprises
a shield layer 720 provided opposite to the pen housing with respect to the first PCB, the second PCB, and the third PCB.

15. The electronic device of any one of claims 1 to 14, wherein
the base plate 481 and the side frame 482 are formed integrally.
